# EUROPEAN PATENT APPLICATION

(11) **EP 4 764 553 A1**
(43) Date of publication of application: **24.06.2026**
(21) Application number: 25857269.2
(22) Date of filing: 08.08.2025
(51) Int. Cl.: G01R 31/392, G01R 31/385, G01R 31/396, G01R 31/367, G01R 19/30, G01R 19/12, H01M 10/42

(54) **BATTERY DIAGNOSIS DEVICE AND METHOD THEREFOR**

(30) Priority: 20.08.2024 KR 20240111113
(71) Applicant: LG Energy Solution, Ltd., Seoul 07335 (KR)
(72) Inventor: KIM, Min Jun, Daejeon 34122 (KR); CHUNG, Mi Kyung, Daejeon 34122 (KR); KOH, Dong Wook, Daejeon 34122 (KR); JEGAL, Seon Young, Daejeon 34122 (KR); CHUN, Joo Young, Daejeon 34122 (KR)
(74) Representative: Plasseraud IP
(86) International application number: PCT/KR2025/012008
(87) International publication number: WO 2026/043180

(57) **Abstract**

According to an embodiment disclosed in this document, there is provided a battery diagnosis device including an interface for acquiring voltage data representing a voltage of a battery cell relative to a capacity of the battery cell and at least one processor, in which the at least one processor is configured to identify first voltage change data of the battery cell acquired in a middle of life (MOL) state, identify a first data range related to a positive electrode of the battery cell in the first voltage change data, transform first sub-data corresponding to the first data range into first linear data in first voltage data corresponding to the first voltage change data based on linear regression, and acquire a positive electrode loss value related to damage to the positive electrode based on the first linear data and diagnose a state of the battery cell based on the positive electrode loss value.

## Description

### TECHNICAL FIELD

### Cross-reference to Related Applications

This application claims priority from Korean Patent Application No. 10-2024-0111113, filed on August 20, 2024, the disclosure of which is incorporated by reference herein.

### Technical Field

Embodiments disclosed in this document relate to a battery diagnosis device and battery diagnosis method.

### BACKGROUND ART

Non-destructive analysis technology refers to evaluating the internal condition and performance of a battery cell without physically damaging the battery cell. Non-destructive analysis technology may be used to verify the effectiveness of new battery designs during a development phase, used for quality control during production process, and used for for performance monitoring and safety assurance during battery cell use. Analyzing a state of the battery cell using half-cell data, such as open circuit potential (OCP) data of the battery cell, has the problem of consuming a lot of computational time. Therefore, research to quantify the degree of degradation of a positive electrode of the battery cell using open circuit voltage (OCV) data needs to be discussed.

### DISCLOSURE OF THE INVENTION

### TECHNICAL PROBLEM

Embodiments disclosed in this document provide a battery diagnosis device and method for diagnosing the state of a battery cell.

Embodiments disclosed in this document provide a battery diagnosis device and method for selectively extracting at least a portion of voltage data of a battery cell.

The technical problems of the embodiments disclosed in the document are not limited to the technical problems mentioned above, and other technical problems not mentioned will be clearly understood by those skilled in the art from the descriptions below.

### TECHNICAL SOLUTION

According to an embodiment disclosed in this document, there is provided a battery diagnosis device including an interface configured to acquire voltage data representing a voltage of a battery cell relative to a capacity of the battery cell, and at least one processor, in which the at least one processor is configured to identify first voltage change data of the battery cell acquired in a middle of life (MOL) state, identify a first data range related to a positive electrode of the battery cell in the first voltage change data, transform first sub-data corresponding to the first data range into first linear data in first voltage data corresponding to the first voltage change data based on linear regression, acquire a positive electrode loss value related to damage to the positive electrode based on the first linear data, and diagnose a state of the battery cell based on the positive electrode loss value.

For example, the at least one processor may be configured to identify a second data range related to the positive electrode of the battery cell in second voltage change data of the battery cell acquired in a beginning of life (BOL) state, and transform second sub-data corresponding to the second data range in second voltage data corresponding to the second voltage change data into second linear data based on linear regression.

For example, the at least one processor may be configured to identify a first slope of the capacity of the battery cell and the voltage of the battery cell using the first linear data, identify a second slope of the capacity of the battery cell and the voltage of the battery cell using the second linear data, and acquire the positive electrode loss value by using a ratio between the first slope and the second slope.

For example, the at least one processor may be configured to identify at least one peak value among a plurality of peak values representing a phase transition of the battery cell in the first voltage change data, and identify the first sub-data corresponding to the first data range based on identifying the at least one peak value.

For example, the at least one processor may be configured to identify the first sub-data in the first voltage data including a data value corresponding to the at least one peak value and a data value corresponding to the maximum capacity of the battery cell in the first voltage data based on identifying the at least one peak value.

For example, the at least one processor may be configured to identify, among the plurality of peak values, the at least one peak value that represents a phase transition occurring at a negative electrode of the battery cell and is located at the end as the capacity of the battery cell increases.

For example, the at least one processor may be configured to diagnose the state of the battery cell by identifying a degree of degradation of the positive electrode of the battery cell using the positive electrode loss value.

For example, the at least one processor may be configured to diagnose the state of the battery cell as an abnormal state when the positive electrode loss value exceeds a designated value.

According to another embodiment disclosed in this document, there is provided a battery diagnosis method including an operation of identifying first voltage change data of the battery cell acquired in a middle of life (MOL) state, an operation of identifying a first data range related to a positive electrode of the battery cell in the first voltage change data, an operation of changing first sub-data corresponding to the first data range into first linear data in first voltage data corresponding to the first voltage change data based on linear regression, an operation of acquiring a positive electrode loss value related to damage to the positive electrode based on the first linear data, and an operation of diagnosing a state of the battery cell based on the positive electrode loss value.

For example, the battery diagnosis method may further include an operation of identifying a second data range related to the positive electrode of the battery cell in second voltage change data of the battery cell acquired in a beginning of life (BOL) state, and an operation of changing second sub-data corresponding to the second data range in second voltage data corresponding to the second voltage change data into second linear data based on linear regression.

For example, the operation of acquiring the positive electrode loss value may further include an operation of identifying a first slope of the capacity of the battery cell and the voltage of the battery cell using the first linear data, an operation of identifying a second slope of the capacity of the battery cell and the voltage of the battery cell using the second linear data, and an operation of acquiring the positive electrode loss value by using a ratio between the first slope and the second slope.

For example, the operation of changing the first sub-data into the first linear data may include an operation of identifying at least one peak value among a plurality of peak values representing a phase transition of the battery cell in the first voltage change data, and an operation of identifying the first sub-data corresponding to the first data range based on identifying the at least one peak value.

For example, the operation of identifying the first sub-data may include an operation of identifying the first sub-data in the first voltage data including a data value corresponding to the at least one peak value and a data value corresponding to the maximum capacity of the battery cell in the first voltage data based on identifying the at least one peak value.

For example, the operation of identifying the at least one peak value may include an operation of identifying, among the plurality of peak values, the at least one peak value that represents a phase transition occurring at a negative electrode of the battery cell and is located at the end as the capacity of the battery cell increases.

For example, the operation of diagnosing the state of the battery cell may include an operation of diagnosing the state of the battery cell as an abnormal state when the positive electrode loss value exceeds a designated value.

### ADVANTAGEOUS EFFECTS

The battery diagnosis device and battery diagnosis method according to the embodiments disclosed in this document can identify a data range for diagnosing the state of a battery using voltage change data.

The battery diagnosis device and battery diagnosis method according to the embodiments disclosed in this document can diagnose the state of the battery using at least a portion of voltage data related to a battery cell.

In addition, various effects that are directly or indirectly identified through this document can be provided.

### BRIEF DESCRIPTION OF THE DRAWINGS

FIG. 1 is a block diagram illustrating a battery pack according to an embodiment disclosed in this document.
FIG. 2 is a block diagram illustrating the configuration of a battery diagnosis device according to an embodiment disclosed in this document.
FIG. 3 illustrates an example of a voltage change graph representing voltage change with respect to capacity change of a battery cell according to an embodiment disclosed in this document.
FIG. 4 illustrates an example of a graph representing linear data transformed based on linear regression according to an embodiment disclosed in this document.
FIG. 5 illustrates an example of a graph representing linear data at a MOL point in time and linear data at a BOL point in time according to an embodiment disclosed in this document.
FIG. 6 is an exemplary flowchart illustrating the operation of a battery diagnosis device according to an embodiment disclosed in this document.
FIG. 7 illustrates a computing system executing a battery diagnosis method according to an embodiment disclosed in this document.

### MODE FOR CARRYING OUT THE INVENTION

Hereinafter, various embodiments of the present invention are described with reference to the accompanying drawings. However, this is not intended to limit the present invention to a specific embodiment, but should be understood to include various modifications, equivalents, and/or alternatives of the embodiments of the present invention.

In this document, a singular form of a noun corresponding to an item may include one item or a plurality of items unless the relevant context clearly indicates otherwise. In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof. Terms such as "first", "second", "firstly", "secondly," may be used merely to distinguish one component from another component and do not limit the components in any other respect (e.g., importance or order). When a component (e.g., a first component) is referred to as being "connected," or "coupled" to another component (e.g., a second component), with or without the terms "functionally" or "communicatively", it means that a component can be connected to another component directly (e.g., in a wired manner), wirelessly, or through a third component.

Each of the components (e.g., modules or programs) described described in this document may include a single or plurality of entities. According to various embodiments, one or more of the components or operations may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

The terms "module" or "... unit" used in this document may include units implemented in hardware, software, or firmware, and may be used interchangeably with terms such as logic, logic block, component, or circuit. A module may be an integrated part, or a minimum unit or portion of the component or a part thereof that performs one or more functions. For example, according to an embodiment, a module may be implemented in the form of an application-specific integrated circuit (ASIC).

Various embodiments of this document may be implemented as software (e.g., a program or application) containing one or more instructions stored in a machine-readable storage medium (e.g., a memory). For example, a processor of the device may call at least one instruction from a storage medium and execute the at least one instruction. This enables the device to operate to perform at least one function in accordance with the called instruction. The one or more instructions may include code generated by a compiler or executable by an interpreter. The machine-readable storage medium may be provided in the form of a non-transitory storage medium. Here, "non-transitory" simply means that the storage medium is a tangible device and does not contain signals (e.g., electromagnetic waves). This term does not distinguish between cases where data is stored semi-permanently and cases where data is stored temporarily.

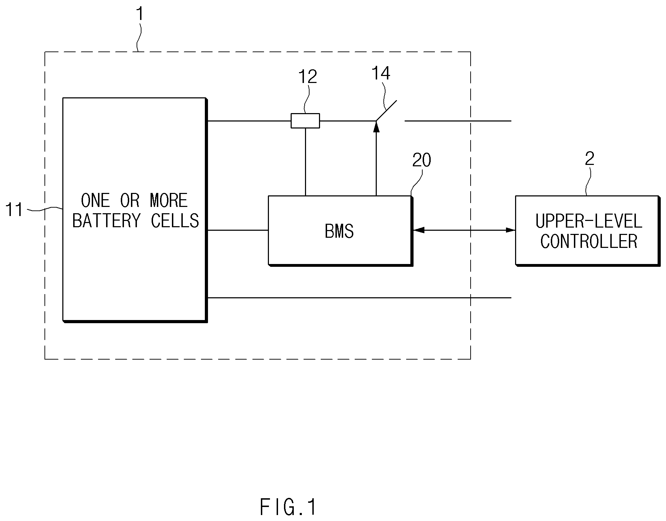

FIG. 1 is a block diagram illustrating a battery pack according to an embodiment disclosed in this document. Referring to FIG. 1, a battery control system including a battery pack 1 and an upper-level controller 2 included in an upper-level system according to an embodiment disclosed in this document is schematically illustrated.

As illustrated in FIG. 1, the battery pack 1 may include one or more battery cells 11, a switching unit 14 connected in series to a first terminal side and/or a second terminal side of one or more battery cells 11 to control charge (and/or discharge) current flow of one or more battery cells 11, and a battery management device 20 that monitors the voltage, current, temperature, etc. of the battery pack 1 to prevent overcharging and overdischarging.

According to various embodiments, the battery pack 1 may be equipped with a plurality of one or more battery cells 11, sensors 12, switching units 14, and battery management systems 20. For example, a first terminal may be a positive (+) terminal of the battery cell 11, and a second terminal may be a negative (-) terminal thereof.

Here, the switching unit 14 is a device for controlling the current flow for charging or discharging one or more battery cells 11, and for example, at least one relay, magnetic contactor, etc. may be used depending on the specifications of the battery pack 1.

One or more battery cells 11 may include a cylindrical battery. The cylindrical battery may refer to a battery in which battery materials are packaged in a cylindrical shape.

The battery management device 20 is an interface that receives values obtained by measuring various parameters described above, and may include a plurality of terminals, a circuit connected to these terminals and performs processing of the received values, etc. In addition, the battery management system 20 may control the ON/OFF of the switching unit 14, for example, a relay or a contactor, and may be connected to the battery cell 11 to monitor the state of each of one or more battery cells 11.

The upper-level controller 2 may transmit a control signal for one or more battery cells 11 to the battery management device 20. Accordingly, the operation of the battery management device 20 may be controlled based on a signal applied from the upper-level controller 2.

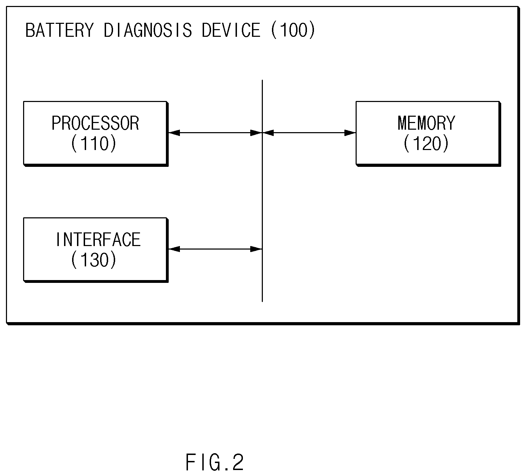

According to an embodiment, the battery management apparatus 20 may include a battery diagnosis device 100 of FIG. 2, which will be described below. According to another embodiment, the battery management device 20 may be another device (or system) different from the battery diagnosis device 100 of FIG. 2. That is, the battery diagnosis device 100 of FIG. 2 may be included in the battery pack 1 or may be configured as another device external to the battery pack 1. For convenience of description, it will be described on the premise that the battery diagnosis device 100 is configured as another device external to the battery pack 1.

FIG. 2 is a block diagram illustrating the configuration of a battery diagnosis device according to an embodiment disclosed in this document. The operation of the battery diagnosis device 100 below may be performed by a battery management system (BMS) related to the battery, and may also be performed in various devices such as a server, cloud, charger, or charger/discharger.

The battery diagnosis device 100 according to an embodiment may include at least one of a processor 110, a memory 120, and an interface 130. The processor 110, the memory 220, and the interface 130 may be electronically and/or operably coupled with each other by an electronic component including a communication bus. Hereinafter, operably coupling pieces of hardware with each other may include a direct connection and/or an indirect connection between pieces of hardware being established in a wired manner and/or wirelessly, such that a second piece of hardware is controlled by a first piece of hardware among the pieces of hardware. Although pieces of hardware are illustrated in different blocks, embodiments are not limited thereto. For example, some of the pieces of hardware of FIG. 2 (e.g., at least a portion of the processor 110, memory 120, and communication circuity (not shown)) may be included in a single integrated circuit, such as a system on a chip (SoC). Communication methods between components may include buses, general purpose input and output (GPIO), serial peripheral interface (SPI), mobile industry processor interface (MIPI), etc.

The processor 110 of the battery diagnosis device 100 according to an embodiment may include a hardware component for processing data based on one or more instructions. Hardware components for processing data may include, for example, an arithmetic and logic unit (ALU), a floating point unit (FPU), a field programmable gate array (FPGA), a central processing unit (CPU), a micro controller unit (MCU), and/or an application processor (AP). The number of processors 110 may be one or more. For example, the processor 110 may have a multi-core processor architecture having dual cores, quad cores, hexa cores, or octa cores.

The memory 120 of the battery diagnosis device 100 according to an embodiment may include hardware components for storing data and/or instructions input and/or output to and from the processor 110. The memory 220 may include, for example, a volatile memory such as a random-access memory (RAM) and/or a non-volatile memory such as a read-only memory (ROM). For example, the volatile memory may include at least one of dynamic RAM (DRAM), static RAM (SRAM), cache RAM, and pseudo SRAM (PSRAM). For example, the non-volatile memory may include at least one of programmable ROM (PROM), erasable PROM (EPROM), electrically erasable PROM (EEPROM), flash memory, a hard disk, a compact disc, a solid state drive (SSD), and an embedded multi-media card (eMMC).

The interface 130 of the battery diagnosis device 100 according to an embodiment may be configured to generate battery measurement values from a battery (e.g., one or more battery cells 11 in FIG. 1). To this end, the interface 130 may include a measuring means such as a voltmeter, an ammeter, a thermometer, and the like, and/or a communication module for establishing a connection with an external device.

For example, the processor 110 may acquire voltage data representing the open circuit voltage of a battery cell in a middle of life (MOL) state using the interface 130. The voltage data may represent the voltage relative to the capacity of a battery cell. The MOL state may indicate a state in which the available capacity of a battery cell is less than the initial available capacity of the battery cell due to the battery cell being used.

For example, the processor 110 may use the interface 130 to acquire voltage data indicating the open circuit voltage of a battery cell in a beginning of life (BOL) state. The BOL state may indicate a state in which the capacity of the battery cell is equal to the initial capacity of the battery cell identified at the time the battery cell was manufactured.

According to an embodiment, the processor 110 may diagnose the state of a battery cell by comparing first voltage data in the MOL state and second voltage data in the BOL state.

According to an embodiment, the processor 110 may acquire first voltage change data indicating a voltage change of a battery cell relative to a capacity change of the battery cell by using the first voltage data identified in the MOL state. For example, the processor 110 may identify a first data range for diagnosing a state of the battery cell in the first voltage change data. For example, the processor 110 may acquire first sub-data corresponding to the first data range from the first voltage data.

The processor 110 according to an embodiment may identify the first data range related to a positive electrode of the battery cell in the first voltage change data of the battery cell acquired in the MOL state. For example, the first voltage change data may include a plurality of peak values indicating a phase transition of the battery cell.

The processor 110 according to an embodiment may identify at least one peak value among a plurality of peak values. For example, the processor 110 may identify the first data range based on identifying at least one peak value.

For example, the processor 110 may identify at least one peak value that represents a phase transition occurring at the negative electrode of a battery cell and is located at the end as the capacity of the battery cell increases, among a plurality of peak values.

For example, the at least one peak value located at the end as the capacity of the battery cell increases may include a peak value due to the negative electrode occurring at phase transition at the very end among the peak values related to the negative electrode. For example, the order of at least one peak value may change depending on the material of the negative electrode. For example, at least one peak value may be located at the sixth of the plurality of peak values when the negative electrode of the battery cell includes a carbon material.

For example, in the first voltage data, a preceding range of at least one peak value may indicate a range in which the negative electrode of the battery cell has a greater influence on the state of the battery than the positive electrode of the battery cell and a subsequent range of at least one peak value may indicate a range in which the positive electrode of the battery cell has a greater influence on the state of the battery than the negative electrode of the battery cell.

For example, the first data range may represent a range from a capacity value corresponding to at least one peak value to a capacity value corresponding to a maximum capacity of the battery cell in the MOL state.

For example, the processor 110 may identify first sub-data corresponding to the first data range in the first voltage data. The first sub-data may include a data value corresponding to the capacity value corresponding to the at least one peak value and a data value corresponding to the capacity value corresponding to the maximum capacity of the battery cell.

The processor 110 according to an embodiment may transform the first sub-data into first linear data based on linear regression. For example, the processor 110 may acquire a loss active material positive (LAMp) value related to damage to the positive electrode of the battery cell based on the first linear data. For example, the processor 110 may diagnose the state of the battery cell based on the LAM_{P} value. The LAMp value may be referred to as a positive electrode loss value.

For example, LAMp may mean a parameter that indicates a degree to which the active material in the positive electrode of a battery cell has decreased due to the battery cell being used. For example, active material loss (e.g., loss active material (LAM)) may occur due to phenomena such as the degree of disorder in a crystal structure within the battery cell and destruction of particles within the negative electrode and positive electrode.

The processor 110 according to an embodiment may identify a second data range related to the positive electrode of the battery cell in second voltage change data of the battery cell acquired in the BOL state. The processor 110 may transform second sub-data corresponding to the second data range from second voltage data corresponding to the second voltage change data into second linear data based on linear regression.

According to one embodiment, the processor 110 may identify a first slope of the capacity of the battery cell and the voltage of the battery cell using the first linear data. For example, the processor 110 may identify a second slope of the capacity of the battery cell and the voltage of the battery cell using the second linear data. The processor 110 may acquire the LAMp value using a ratio between the first slope and the second slope.

For example, the LAMp value may represent a value obtained by subtracting the ratio of the second slope to the first slope from 1.

The processor 110 according to an embodiment may diagnose the state of the battery cell by identifying the degree of degradation of the positive electrode of the battery cell using the LAMp value. For example, since the first data range (or the second data range) representing a range after at least one peak value was used to acquire the LAMp value, the LAMp value may represent the degree of degradation of the positive electrode.

For example, the processor 110 may diagnose the state of the battery cell as an abnormal state when the LAMp value exceeds a designated value. For example, when the LAMp value is less than the designated value, the processor 110 may diagnose the state of the battery cell as a normal state. However, it is not limited to this.

For example, the processor 110 may control the battery cell using a diagnosis result obtained by diagnosing the state of the battery cell. The processor 110 may provide a diagnosis result obtained by diagnosing the state of the battery cell to an external object (e.g., a user). The processor 110 may display an image indicating the diagnosis result obtained by diagnosing the state of the battery cell on a display (not shown).

The battery diagnosis device 100 according to an embodiment as described above may acquire the degree of degradation of the positive electrode degradation of the battery cell by using at least a portion (e.g., sub-data) of voltage data indicating the open circuit voltage of the battery cell. The battery diagnosis device 100 may diagnose the state of the battery cell using the voltage data without the need to use open circuit potential positive (OCPp) data and open circuit potential negative (OCPn) data representing half-cell data in order to acquire the degree of degradation of the positive electrode of the battery cell. The battery diagnosis device 100 may quantify the degree of degradation of the positive electrode of the battery cell based on relatively less data (or a small computational amount) than using half-cell data, by using at least a part of the voltage data.

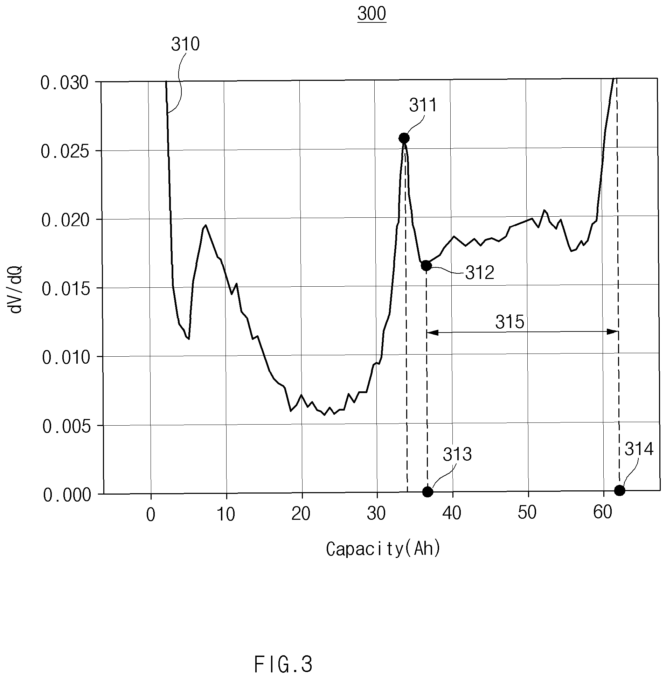

Hereinafter, with reference to FIG. 3, the operation of the battery diagnosis device 100 identifying a data range in voltage change data of the battery cell acquired in the MOL state will be described in more detail below.

FIG. 3 illustrates an example of a voltage change graph representing a voltage change relative to capacity change of a battery cell according to an embodiment disclosed in this document. The battery cell of FIG. 3 may be included in one or more battery cells 11 of FIG. 1. The battery diagnosis device of FIG. 3 may be referenced to the battery diagnosis apparatus 100 of FIG. 2. In an embodiment, a graph 300 may include first voltage change data 310 acquired from a battery cell in a MOL state. The first voltage change data 310 may represent a voltage change of the battery cell according to a capacity change of the battery cell.

Referring to the graph 300, the battery diagnosis device 100 according to an embodiment may identify a plurality of peak values in the first voltage change data 310. For example, the plurality of peak values may represent a phase transition (or phase equilibrium) of the battery cell.

The battery diagnosis device 100 according to one embodiment may identify at least one peak value 311 among a plurality of peak values. The at least one peak value 311 may be located at the sixth position among the plurality of peak values in the first voltage change data 310 according to an increase in the capacity of the battery cell.

For example, based on identifying at least one peak value 311, the battery diagnosis device 100 may confirm that the value of the first voltage change data 310 decreases. For example, the battery diagnosis device 100 may confirm that the value of the first voltage change data 310 is reduced and then increases based on identifying at least one peak value 311. In other words, the battery diagnosis device 100 may identify an inflection point 312 at which the slope of the first voltage change data 310 changes from negative to positive based on identifying at least one peak value 311.

The battery diagnosis device 100 according to an embodiment may identify a first data range 315 representing a range from a first capacity value 313 of a battery cell corresponding to the inflection point 312 to a capacity value 314 representing a maximum capacity of the battery cell in the MOL state. The first data range 315 may represent a range in which the influence on the positive electrode of the battery cell is greater among the negative electrode of the battery cell and the positive electrode of the battery cell.

The battery diagnosis device 100 according to an embodiment may acquire second voltage data from the battery cell in the BOL state, and acquire second voltage change data from the second voltage data. For example, the second voltage data may represent a voltage of the battery cell relative to the capacity of the battery cell in the BOL state, and the second voltage change data may represent a voltage change of the battery cell relative to the capacity change of the battery cell in the BOL state.

The battery diagnosis device 100 according to an embodiment may acquire the second data range by repeatedly performing an operation, in which the battery diagnosis device 100 acquires the first data range 315 using the first voltage change data, by using the second voltage change data.

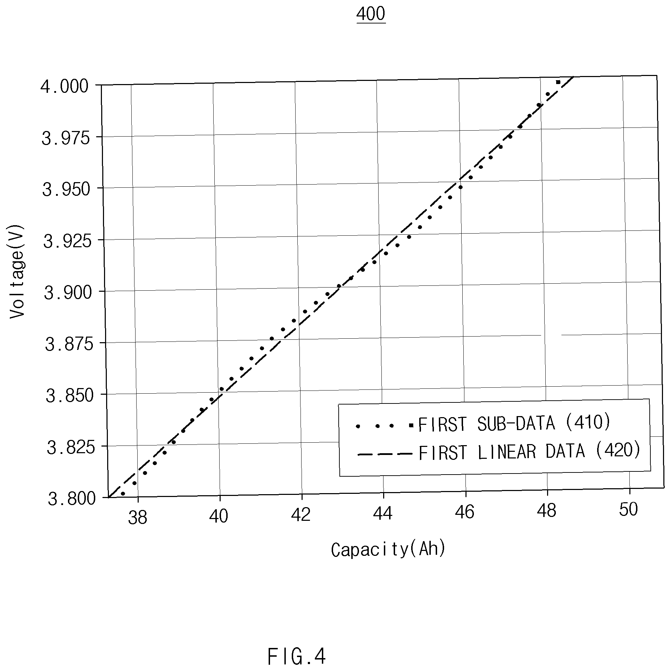

Hereinafter, with reference to FIG. 4, the operation in which the battery diagnosis device 100 acquires sub-data from voltage data using the data range and performs linear regression on the sub-data will be described in more detail below.

FIG. 4 illustrates an example of a graph showing linear data transformed based on linear regression according to an embodiment disclosed in the present document. The battery cell of FIG. 4 may be included in one or more battery cells 11 of FIG. 1. The battery diagnosis device of FIG. 4 may be referenced to the battery diagnosis device 100 of FIG. 2. A graph 400 may include first sub-data 410 indicating at least a portion of the first voltage data for the battery cell in the MOL state. The first voltage data may represent the voltage of the battery cell relative to the capacity of the battery cell in the MOL state. The graph 400 may include first linear data 420 obtained by changing the first sub-data 410 based on a linear regression.

The battery diagnosis device 100 according to an embodiment may identify (or crop) first sub-data 410 corresponding to the first data range 315 of FIG. 3 in (from) the first voltage data acquired in the MOL state.

The battery diagnosis device 100 according to an embodiment may transform the first sub-data 410 into the first linear data 420 based on the linear regression. For example, the battery diagnosis device 100 may transform the first sub-data 410 into the first linear data 420 through linear regression based on ordinary least squares (OLS), weighted least squares (WLS), generalized least squares (GLS), lasso regression, ridge regression, and/or elastic net.

Similarly, the battery diagnosis apparatus 100 according to an embodiment may identify second sub-data corresponding to the second data range in the second voltage data acquired in the BOL state.

The battery diagnosis device 100 according to one embodiment as described above may reduce the amount of computation required to diagnose the state of a battery by extracting sub-data related to the positive electrode from voltage data.

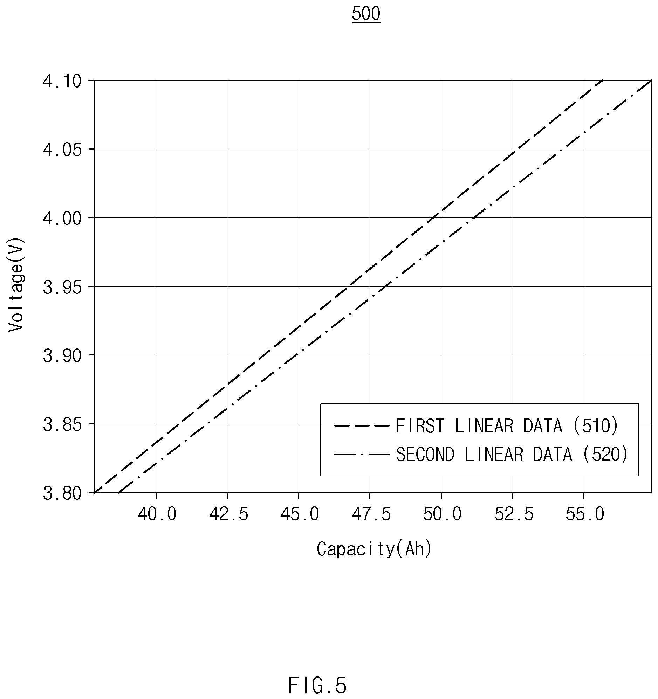

Hereinafter, with reference to FIG. 5, an example of an operation in which the battery diagnosis apparatus 100 diagnoses the state of a battery cell by comparing first linear data for a battery cell in the MOL state and second linear data for a battery cell in the BOL state will be described in more detail below.

FIG. 5 illustrates an example of a graph representing linear data at the MOL point in time and linear data at the BOL point in time according to an embodiment disclosed in this document. The battery cell of FIG. 5 may be included in one or more battery cells 11 of FIG. 1. The battery diagnosis device of FIG. 5 may be referenced to the battery diagnosis device 100 of FIG. 2. The graph 500 may include first linear data 510 related to a battery cell in the MOL state and second linear data 520 related to a battery cell in the BOL state. The first linear data 510 may represent a voltage relative to the capacity of the battery cell in the MOL state, and the second linear data 520 may represent a voltage relative to the capacity of the battery cell in the BOL state. The first linear data 510 may be referenced to the first linear data 420 of FIG. 4.

Referring to the graph 500, it may be confirmed that the slope of the first linear data 510 acquired in the MOL state is greater than the slope of the second linear data 520 acquired in the BOL state. Since the voltage data has shrunk with respect to the capacity axis as the battery cell in the MOL state has undergone degradation, the slope of the first linear data 510 may be greater than the slope of the second linear data 520.

Referring to the graph 500, the battery diagnosis device 100 according to an embodiment may acquire an LAMp value using the first linear data 510 and the second linear data 520.

The battery diagnosis device 100 according to an embodiment may identify a first slope indicating the slope of the first linear data 510. For example, the battery diagnosis device 100 may identify the first slope of the voltage of the battery cell and the capacity of the battery cell using the first linear data.

For example, the battery diagnosis device 100 may identify a second slope indicating the slope of the second linear data 520.

The battery diagnosis device 100 according to an embodiment may acquire the LAMp value based on a ratio between the first slope and the second slope.

For example, the battery diagnosis device 100 may diagnose the state of the battery cell as an abnormal state when the LAMp value exceeds a designated value. For example, when the LAMp value is less than the designated value, the battery diagnosis device 100 may diagnose the state of the battery cell as a normal state. However, it is not limited thereto.

As described above, the battery diagnosis device 100 according to an embodiment may reduce the computation time for diagnosing the state of a battery cell by diagnosing the state of the battery cell using the slope of at least a portion of voltage data.

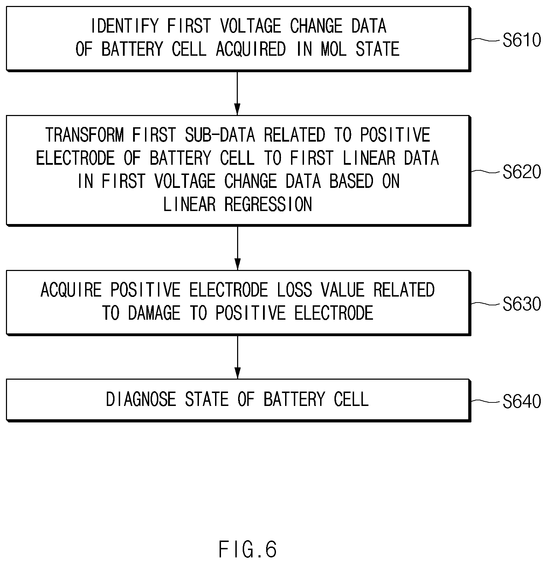

FIG. 6 is an exemplary flowchart illustrating a battery diagnosis method according to an embodiment disclosed in this document. Hereinafter, it is assumed that the battery diagnosis device 100 of FIG. 2 performs the process of FIG. 6. In addition, the operations described as being performed by the device may be understood as being controlled by the processor 110 of the battery diagnosis device 100. Each of the operations in FIG. 6 may be performed sequentially, but are not necessarily performed sequentially. For example, the order of each of the operations may be changed, and at least two operations may be performed in parallel.

Referring to FIG. 6, in operation S610, the battery diagnosis device may identify first voltage change data of the battery cell acquired in the MOL state.

For example, the battery diagnosis device may acquire first voltage data for a battery cell in the MOL state through an interface (e.g., an interface 130 of FIG. 2). The first voltage data may represent the voltage relative to the capacity of the battery cell.

For example, the battery diagnosis device may identify the first voltage change data (e.g., the first voltage change data 310 of FIG. 3) in the first voltage data. The first voltage change data may be acquired using the slope of the first voltage data. The first voltage change data may represent a voltage change with respect to a capacity change of a battery cell in the MOL state.

Referring to FIG. 6, in operation S620, the battery diagnosis device may transform the first sub-data (e.g., the first sub-data 410 of FIG. 4) related to the positive electrode of the battery cell to the first linear data (e.g., first linear data 420 of FIG. 4) in the first voltage change data based on linear regression.

For example, the battery diagnosis device may identify at least one peak value located at the sixth position according to the change in capacity among a plurality of peak values included in the first voltage change data. The battery diagnosis device may identify the first data range (e.g., the first data range 315 of FIG. 3) for identifying at least a portion of the first voltage data based on identifying at least one peak value.

For example, the battery diagnosis device may identify the first sub-data corresponding to the first data range in the first voltage data based on identifying the first data range.

For example, the battery diagnosis device may acquire second linear data (e.g., second linear data 520 of FIG. 5) related to a battery cell in the BOL state by performing operations S610 and S620 using second voltage change data in the BOL state.

Referring to FIG. 6, in operation S630, the battery diagnosis device may acquire a positive electrode loss value related to damage to the positive electrode. The positive electrode loss value may represent a LAMp value.

For example, the battery diagnosis device may acquire the positive electrode loss value by using the first slope of the first sub-data and the second slope of the second sub-data.

For example, the battery diagnosis device may define the LAMp value as the value obtained by subtracting the ratio of the second slope to the first slope from a designated value (e.g., 1).

Referring to FIG. 6, in operation S640, the battery diagnosis device may diagnose the state of a battery cell.

For example, the battery diagnosis device may diagnose the state of a battery cell using the LAMp value obtained based on the slope of the first sub-data and the slope of the second sub-data.

For example, the battery diagnosis device may diagnose the state of a battery cell using the LAMp value that indicates the degree of degradation of the positive electrode of the battery cell.

For example, the battery diagnosis device may diagnose the state of the battery cell as an abnormal state when the LAMp value exceeds a designated value, and may diagnose the state of the battery cell as a normal state when the LAMp value does not exceed the designated value. However, it is not limited thereto.

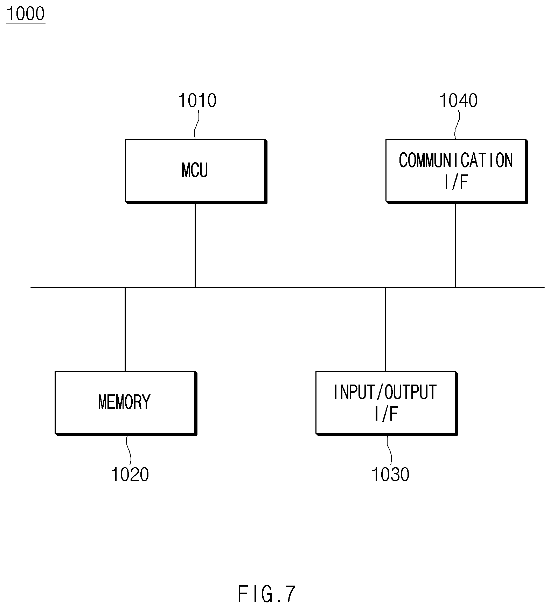

FIG. 7 illustrates a computing system executing a battery diagnosis method according to an embodiment disclosed in this document.

Referring to FIG. 7, a computing system 1100 according to an embodiment disclosed in this document may include an MCU 1010, a memory 1020, an input/output I/F 1030, and a communication I/F 1040.

The MCU 1010 may be a processor that executes various programs stored in the memory 1020, processes various information including battery data through these programs, and performs the functions of the processor (or control unit) included in the battery diagnosis device 100 illustrated in the aforementioned FIG. 2.

The memory 1020 may store various programs for performing the functions of the power management device. In addition, the memory 1020 may store various types of information including battery data (voltage data, capacity data, etc.), differential capacity data, etc., and may include a constructed database.

A plurality of such memories 1020 may be provided as needed. The memory 1020 may be a volatile memory or a nonvolatile memory. The memory 1020 used as the volatile memory may be RAM, DRAM, SRAM, etc. The memory 1020 used as the nonvolatile memory may be ROM, PROM, EAROM, EPROM, EEPROM, flash memory, etc. The examples of the memories 1020 listed above are only examples and are not limited to these examples.

The input/output I/F 1030 may provide an interface that allows data to be transmitted and received by connecting an input device (not shown) such as a keyboard, mouse, or touch panel and an output device (not shown) such as a display with the MCU 1010.

The communication I/F 1040 is a configuration that can transmit and receive various data with the server, and may be various devices that can support wired or wireless communication. For example, the power management device may transmit and receive various types of information, including battery data, from a separately provided external server, etc., through the communication I/F 1040.

In this way, the computer program according to an embodiment disclosed in this document may be implemented as a module that performs each function illustrated in FIG. 1, for example, by being recorded in the memory 1020 and processed by the MCU 1010.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an example of the technical idea disclosed in this document, and those skilled in the art to which the embodiments disclosed in this document pertain may make various modifications and variations without departing from the essential characteristics of the embodiments disclosed in this document. Accordingly, the embodiments disclosed in this document are intended to describe rather than limit the technical ideas of the embodiments disclosed in this document, and the scope of the technical ideas disclosed in this document is not limited by these embodiments. The scope of protection of the technical ideas disclosed in this document should be interpreted by the scope of the claims below, and all technical ideas within the equivalent scope should be interpreted as being included in the scope of rights of this document.

## Claims

1. A battery diagnosis device comprising:
an interface configured to acquire voltage data representing a voltage of a battery cell relative to a capacity of the battery cell; and
at least one processor,
wherein the at least one processor is configured to:
identify first voltage change data of the battery cell acquired in a middle of life (MOL) state;
identify a first data range related to a positive electrode of the battery cell in the first voltage change data;
transform first sub-data corresponding to the first data range into first linear data in first voltage data corresponding to the first voltage change data based on linear regression;
acquire a positive electrode loss value related to damage to the positive electrode based on the first linear data; and
diagnose a state of the battery cell based on the positive electrode loss value.

2. The battery diagnosis device of claim 1, wherein the at least one processor is configured to:
identify a second data range related to the positive electrode of the battery cell in second voltage change data of the battery cell acquired in a beginning of life (BOL) state; and
transform second sub-data corresponding to the second data range in second voltage data corresponding to the second voltage change data into second linear data based on linear regression.

3. The battery diagnosis device of claim 2, wherein the at least one processor is configured to:
identify a first slope of the capacity of the battery cell and the voltage of the battery cell using the first linear data;
identify a second slope of the capacity of the battery cell and the voltage of the battery cell using the second linear data; and
acquire the positive electrode loss value by using a ratio between the first slope and the second slope.

4. The battery diagnosis device of claim 1, wherein the at least one processor is configured to:
identify at least one peak value among a plurality of peak values representing a phase transition of the battery cell in the first voltage change data; and
identify the first sub-data corresponding to the first data range based on identifying the at least one peak value.

5. The battery diagnosis device of claim 4, wherein the at least one processor is configured to identify the first sub-data in the first voltage data including a data value corresponding to the at least one peak value and a data value corresponding to the maximum capacity of the battery cell in the first voltage data based on identifying the at least one peak value.

6. The battery diagnosis device of claim 5, wherein the at least one processor is configured to identify, among the plurality of peak values, the at least one peak value that represents a phase transition occurring at a negative electrode of the battery cell and is located at the end as the capacity of the battery cell increases.

7. The battery diagnosis device of claim 1, wherein the at least one processor is configured to diagnose the state of the battery cell by identifying a degree of degradation of the positive electrode of the battery cell using the positive electrode loss value.

8. The battery diagnosis device of claim 1, wherein the at least one processor is configured to diagnose the state of the battery cell as an abnormal state when the positive electrode loss value exceeds a designated value.

9. A battery diagnosis method comprising:
an operation of identifying first voltage change data of the battery cell acquired in a middle of life (MOL) state;
an operation of identifying a first data range related to a positive electrode of the battery cell in the first voltage change data;
an operation of transforming first sub-data corresponding to the first data range into first linear data in first voltage data corresponding to the first voltage change data based on linear regression;
an operation of acquiring a positive electrode loss value related to damage to the positive electrode based on the first linear data; and
an operation of diagnosing a state of the battery cell based on the positive electrode loss value.

10. The battery diagnosis method of claim 9, further comprising:
an operation of identifying a second data range related to the positive electrode of the battery cell in second voltage change data of the battery cell acquired in a beginning of life (BOL) state; and
an operation of transforming second sub-data corresponding to the second data range in second voltage data corresponding to the second voltage change data into second linear data based on linear regression.

11. The battery diagnosis method of claim 10, wherein the operation of acquiring the positive electrode loss value further includes:
an operation of identifying a first slope of the capacity of the battery cell and the voltage of the battery cell using the first linear data;
an operation of identifying a second slope of the capacity of the battery cell and the voltage of the battery cell using the second linear data; and
an operation of acquiring the positive electrode loss value by using a ratio between the first slope and the second slope.

12. The battery diagnosis method of claim 9, wherein the operation of changing the first sub-data into the first linear data includes:
an operation of identifying at least one peak value among a plurality of peak values representing a phase transition of the battery cell in the first voltage change data; and
an operation of identifying the first sub-data corresponding to the first data range based on identifying the at least one peak value.

13. The battery diagnosis method of claim 12, wherein the operation of identifying the first sub-data includes an operation of identifying the first sub-data in the first voltage data including a data value corresponding to the at least one peak value and a data value corresponding to the maximum capacity of the battery cell in the first voltage data based on identifying the at least one peak value.

14. The battery diagnosis method of claim 13, wherein the operation of identifying the at least one peak value includes an operation of identifying, among the plurality of peak values, the at least one peak value that represents a phase transition occurring at a negative electrode of the battery cell and is located at the end as the capacity of the battery cell increases.

15. The battery diagnosis method of claim 9, wherein the operation of diagnosing the state of the battery cell includes an operation of diagnosing the state of the battery cell as an abnormal state when the positive electrode loss value exceeds a designated value.
